# EUROPEAN PATENT APPLICATION

(11) **EP 4 664 692 A1**
(43) Date of publication of application: **17.12.2025**
(21) Application number: 25180517.2
(22) Date of filing: 03.06.2025
(51) Int. Cl.: H01S 5/10, H01S 5/02, H01S 5/0687, H01S 5/14, H01S 5/40

(54) **HYBRID INTEGRATED NARROW-LINEWIDTH OPTICAL FREQUENCY COMB**

(30) Priority: 11.06.2024 US 202418739785
(71) Applicant: Nokia Solutions and Networks Oy, 02610 Espoo (FI)
(72) Inventor: IDJADI, Mohamad Hossein, Chatham (US); GRILLANDA, Stefano, Springfield (US)
(74) Representative: Nokia EPO representatives

(57) **Abstract**

An optical circuit includes a frequency comb laser outputting N channels of light on a single path, an optical splitter splitting the output from laser into three light paths, a first light path as a laser output, a second light path as a reference laser, and a third light path. A high quality factor cavity filter is coupled with the third path. A first wavelength demultiplexer (WDM) is coupled with the second light path configured to demultiplex the light in the second light path into N outputs. A second WDM is coupled with the third light path configured to demultiplex the light in the third light path into N outputs. A mixing circuit is coupled with the N outputs from the first WDM and the N outputs from the second WDM, and has 2N outputs. The mixing circuit is configure to directionally couple the 2 signals for each wavelength (λ_{N}) and to output into 2N waveguides the directionally coupled light paths.

## Description

### TECHNOLOGICAL FIELD

The present invention relates to the field of narrow linewidth lasers and in particular, lasers with multiple output channels.

### BACKGROUND

Lasers, as an optical clock, are at the heart of advanced optical systems. Lasers normally emit light at a single optical frequency and are basically made by a gain medium inside an optical cavity. Due to different random noise processes, the laser frequency fluctuates randomly; this phenomenon is called laser frequency noise. Ideally, a laser with minimal frequency noise is desired for almost all the applications in optics.

On the other hand, new technologies have enabled lasers that emit light at multiple wavelengths simultaneously. These lasers are called "frequency comb" laser as their output spectrum contains multiple frequencies. Optical frequency combs are being used in different applications in optics such as optical communication, sensing, and microwave-photonics. The output power distribution in optical frequency combs is usually not uniform and the optical power per comb line is also in the order of a few mW.

### SUMMARY OF THE INVENTION

The scope of protection sought for various embodiments of the invention is set out by the independent claims. The embodiments and features, if any, described in this Specification that do not fall under the scope of the independent claims are to be interpreted as examples useful for understanding various embodiments of the invention.

The present invention provides narrow linewidth lasers and in particular, apparatuses and methods that enable a laser to produce multiple output channels (i.e. multiple wavelengths) with extremely narrow linewidth (i.e. very low frequency noise) and high optical power per channel, uniform power distribution, and a high degree of correlation.

The present invention addresses the problem of stabilizing the channels of a multi-wavelength laser. In particular, the present invention allows to dramatically reduce the frequency noise spectrum of the output channels of the laser.

According to embodiments of the present invention, an apparatus may be composed of a multi-wavelength, high-power-per-channel laser together with a stabilization system. The present invention allows for a large number of output channels (wavelengths) with high optical power; narrow linewidth and low frequency noise for each of the output wavelengths; and a high degree of correlation among the output channels of the laser.

According to embodiments of the invention, an apparatus with two main sub-systems is provided: an optical frequency comb laser and a broadband laser frequency locking circuit. According to embodiments of the invention, the optical frequency comb synthesizes multiple wavelengths with high optical power per comb line and uniform power distribution. Despite high-power and relatively narrow-linewidth spectral shape, the generated frequencies can have a low degree of mutual correlation.

According to embodiments of the invention, the broadband laser frequency locking circuit receives all the channels (i.e., frequencies) of the comb, measures frequency fluctuations of each channel by comparing it with the corresponding resonance frequency of a common reference (i.e., a high-Q optical resonator), coherently interfering it with a copy of the channel, and generates a corresponding electrical control signal (e.g., error signal) for each channel. The amplitude of the electronic error signal for each channel corresponds to its frequency noise. The control signal may be used to modulate bias current of the corresponding channel and hence, correct frequency fluctuations and lock all the frequencies simultaneously to a common frequency reference. As a result, the output contains multiple high power comb lines with high degree of correlation.

According to embodiments of the present invention, a photonic integrated circuit (PIC) is provided that includes an optical frequency comb laser and a broadband laser frequency locking circuit. According to embodiments of the present invention, the PIC is completely passive.

According to embodiments of the present invention, a laser module assembly is provided including the PIC coupled with control electronics. Light sources are coupled with the PIC to effect lasing. The control electronics are configured to measure an error signal from the output of the PIC for each channel N and control the light sources to lock each frequency.

According to embodiments of the invention, an optical circuit includes an N by 1 channel arrayed waveguide grating (AWG) having N inputs and 1 output; an output mirror coupled with the output of the AWG; an optical splitter splitting the output from the output mirror into three light paths, a first light path as a laser output, a second light path as a reference laser, and a third light path; a high quality factor cavity filter coupled with the third path; a first wavelength demultiplexer (WDM) coupled with said second light path configured to demultiplex the light in said second light path into N outputs; a second WDM coupled with said third light path configured to demultiplex the light in said third light path into N outputs; a mixing circuit coupled with the N outputs from the first WDM and the N outputs from the second WDM, having 2N outputs, and configured to directionally couple wavelengths (λₙ) of light outputs from the first WDM with corresponding wavelengths (λₙ) of light outputs from the second WDM, and to output into 2N waveguides the directionally coupled light paths.

According to embodiments of the invention, the optical circuit is formed in a photonic integrated circuit (PIC) on a single chip.

According to embodiments of the invention, N waveguides route light from a facet of the circuit to the N inputs of the AWG.

According to embodiments of the invention, the output mirror is implemented as a Sagnac loop positioned between the output of the AWG and the optical splitter.

According to embodiments of the invention, the AWG is a double-chirped design configured to suppress transmission in free-spectral-ranges other than the one of interest.

According to embodiments of the invention, the AWG is implemented in a passive ultra-low loss integrated photonic platform (e.g. silicon nitride, silicon oxynitride or silica-on-silicon).

According to embodiments of the invention, each WDM comprises an array of N ring resonators, each resonator being aligned with one of the wavelengths (λₙ).

According to embodiments of the invention, each WDM comprises an 1 to N channel AWG, with each channel being aligned with one of the wavelengths (λₙ).

According to embodiments of the invention, the mixing circuit comprises ultra-low-loss waveguide crossings such that every outputs of the first WDM and of the second WDM that have corresponding wavelengths (λₙ) are interfered with using a directional coupler or a multi-mode interferometer.

According to embodiments of the invention, an apparatus includes the optical circuit described above, and an array of N reflective semiconductor optical amplifiers (RSOAs) each RSOA being optically coupled with an input of the N inputs of the AWG and configured to emit broadband light. Each passband of the AWG selects (or filters) a narrow wavelength range (λₙ) from the broadband emission of each RSOA (i.e., passband 1 filters the light emitted by RSOA 1, passband 2 filters the light emitted by RSOA 2 etc.). The light emitted by each RSOA is combined by the AWG onto the same waveguide after being wavelength-filtered. The apparatus also includes a control circuit optically coupled with the 2N outputs of said mixer circuit and electrically coupled with the array of N RSOAs, and configured to modulate the bias current of each of the N RSOAs based on a frequency noise measurement (i.e. the error signal) of a corresponding output of the 2N outputs of said mixer circuit. Changing the bias current of the RSOA of a channel will introduce a phase shift and hence will change the lasing frequency.

According to embodiments of the invention, the control circuit is further configured to modulate the bias current to one or more of said N RSOAs to suppress frequency noise and lock each channel to its corresponding resonance frequency of the frequency reference at wavelength λₙ.

According to embodiments of the invention, an array of photodetectors is optically coupled with each of the 2N outputs of said mixing circuit and electronically coupled with said control circuit.

According to embodiments of the invention, the comb line frequency spacing is a multiple integer of the free-spectral-range (FSR) of the resonator.

According to embodiments of the invention, each RSOA is biased with an excitation current in the range of 0 to 300mA.

According to embodiments of the invention, the channel spacing can be designed in the range of 50-400 GHz, such as, for example, 50 GHz, 100 GHz, 200 GHz, or 400 GHz.

According to embodiments of the invention, a method is provided for locking multiple laser channels, comprising steps of providing an optical circuit comprising: N optical inputs; an N by 1 channel arrayed waveguide grating (AWG) having N inputs and 1 output, said N inputs of said AWG being optically coupled with the N optical inputs; an output mirror coupled with the output of the AWG; an optical splitter splitting the output from the output mirror into three light paths, a first light path as a laser output, a second light path as a reference laser, and a third light path; a high quality factor cavity filter coupled with the third path; a first wavelength demultiplexer (WDM) coupled with said second light path configured to demultiplex the light in said second light path into N outputs; a second WDM coupled with said third light path configured to demultiplex the light in said third light path into N outputs; a mixing circuit coupled with the N outputs from the first WDM and the N outputs from the second WDM, having 2N outputs, and configured to directionally couple wavelengths (λₙ) of light outputs from the first WDM with corresponding wavelengths (λₙ) of light outputs from the second WDM, and to output into 2N waveguides the directionally coupled light paths; receiving N light emissions into said N inputs from a plurality of N current-tunable light sources, each emission being filtered to a different wavelength (λₙ); comparing each corresponding output of the 2N outputs of said mixer circuit of a same wavelength λₙ; adjusting the frequency of the current-controlled frequency-tunable laser channel λₙ based on the measured error signal of the corresponding channel.

According to embodiments of the invention, the N current-tunable light sources are RSOAs and the tuning step is adjusting the gain of the corresponding RSOA.

According to embodiments of the invention, the tuning step includes adjusting an excitation current to one or more of said N RSOAs to modulate frequency, reduce noise, and lock each channel to a wavelength λₙ.

According to embodiments of the invention, an array of photodetectors is optically coupled with each of the 2N outputs of said mixing circuit and electronically coupled with a control circuit configured to perform the comparing and tuning steps.

The invented architecture is scalable and can be used for many applications, and in particular for ultra-high baud rate communications and for fiber optic sensing.

Other aspects in accordance with the invention will become apparent from the following detailed description, taken in conjunction with the accompanying drawings, illustrated by way of example of the principles of the invention.

### BRIEF DESCRIPTION OF DRAWINGS

Embodiments of the present invention are illustrated by way of example with reference to the accompanying drawings, which should not be construed to limit the present disclosure.
FIG. 1(a) is a top view schematic of an optical circuit according to embodiments of the present invention.
FIG. 1(b) is a side view schematic of a comb laser according to embodiments of the present invention.
FIG. 2 is a diagram showing alignment of ring resonator resonances with wavelengths of a comb laser according to embodiments of the present invention.
FIG. 3(a) is a diagram of an architecture of a wavelength de-multiplexor according to an embodiment of the present invention.
FIG. 3(b) is a diagram of an architecture of a wavelength de-multiplexor according to another embodiment of the present invention.
FIG. 4 is a diagram of a mixing circuit architecture according to embodiments of the present invention.
FIGS. 5(a) and 5(b) illustrate a conceptual diagram of laser frequency noise discrimination and generation of the error signal according to embodiments of the present invention.

### DETAILED DESCRIPTION OF THE PREFERRED EMBODIMENTS

The following descriptions are presented to enable any person skilled in the art to create and use apparatuses, systems and methods described herein.

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

Conventional optical frequency combs are based on a non-linear effect to synthesize multiple optical frequencies from an input pump laser (e.g., frequency combs based on Kerr or electro-optic effect). In such technologies, there is a challenging tradeoff between different critical parameters such as: optical power per comb line, total number of generated frequencies (i.e. comb lines), uniformity of power across the spectrum, and frequency stability of each comb line.

To break this tradeoff, embodiments of the present invention provide a frequency comb architecture that is integrated with a novel broadband modulation-free frequency locking system.

According to embodiments of the invention, an optical frequency comb architecture can synthesize scalable frequency comb lines without sacrificing total optical power and uniformity of the power across the spectrum. Moreover, all the synthesized frequencies may be frequency locked to a high-quality factor cavity acting as an optical frequency reference. The broadband laser frequency locking scheme locks all the frequency channels and generates a high degree of correlation between the output wavelengths of the laser. The invention provides a high power per comb line, uniform spectrum, narrow-linewidth spectral shape, and coherency between generated frequencies.

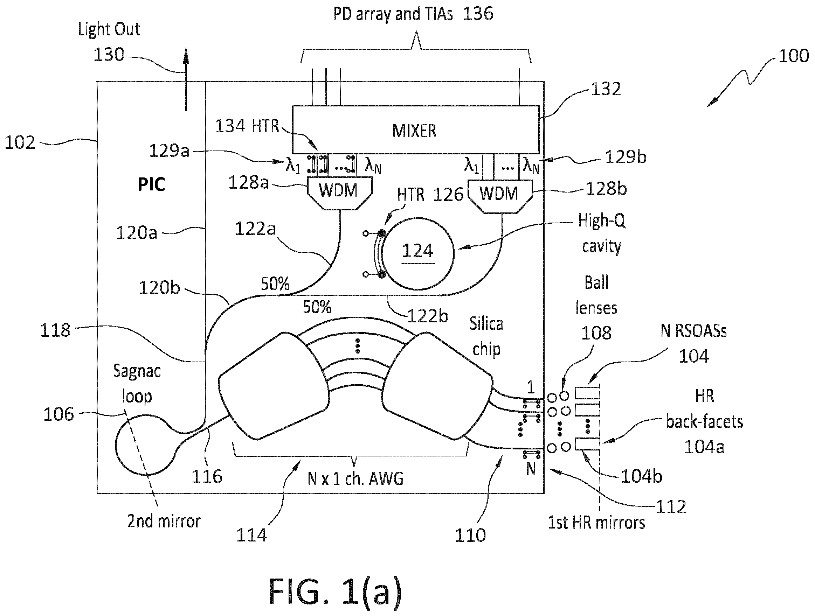

FIG. 1(a) illustrates a top-view schematic of an optical circuit for a frequency-noise stabilized multi-wavelength laser according to embodiments of the present invention. Comb laser 100 includes a photonic integrated circuit (PIC) 102 and N reflective semiconductor optical amplifiers (RSOAs) 104, one for each channel N of the laser 100. The PIC 102 includes two mirrors that form the laser cavity. The RSOAs 104 have a highly reflective (HR) back facet 104a, each of which behaves as first HR mirror of the laser and a second partial reflectivity front facet 104b. Second mirror 106, in this example, formed by a Sagnac loop 106, together with the RSOAs 104, form a laser cavity. Light from each of the RSOAs 104 is coupled to the chip 102 by means of a lens or lenses 108, which, in this example, include a pair of ball lenses 108, for each channel (in total: N x 2 = 2N lenses with N channels). N waveguides 110 route the light for each channel from the chip facet 112 to an N x 1 arrayed waveguide grating (AWG) 114.

The AWG 114 is preferably implemented with a specific AWG design, named "double-chirped" design, which may suppress transmission in free-spectral-ranges (FSRs) adjacent to that of interest, so that for every wavelength (λ_{N}) there is only one transmission passband. The double chirped design enables also monomode emission from the laser.

The AWG 114 should be designed to suppress periodicity and preferably has two functionalities: (i) first, it should allow passbands selected of a narrow wavelength range from the broadband emission spectrum of the RSOAs 104; and (2) second, it should behave as a wavelength multiplexer to combine all channels (λ_{N}) on the same output waveguide 116. Part of the light at the AWG output waveguide 116 is reflected back by a second mirror 106 which, in this example, is implemented by Sagnac loop 106. The remaining part of the light is transmitted through the second mirror 106.

By increasing the electric current applied to the RSOAs 104, lasing is effected on a given channel (N) when the round-trip gain in the laser cavity (from RSOA back-facet 104a to Sagnac loop 106) is equal to or higher than the round-trip loss. As a matter of example, when the AWG 114 is implemented with silica-on-silicon waveguides and III-V based RSOAs 104 are biased in the range from 0 to 300 mA, the typical optical output power levels per channel can be as high as 11 dBm with Lorentzian linewidth on the scale of less than 1 kHz.

RSOAs 104 preferably have a gain spectrum of several tens of nanometers. The AWG 114 passband can be designed to select an arbitrary wavelength range. A typical value of passband for AWG 114 with 100 GHz channel spacing may be about 40-45 GHz at -1 dB from the peak transmission. Also, typical values of passbands for AWG 114 with channel spacing of 50 GHz, 200 GHz, 400 GHz may be, respectively, about 20-25 GHz, 80-90 GHz, 170-180 GHz at -1 dB from the peak transmission.

When changing the current on each RSOA there are two phenomena: the RSOA gain and hence the total optical power emitted by the RSOA varies; and the effective optical length of the waveguide of the RSOA changes (by injecting current into the RSOA, the number of free carriers in the RSOA changes, and this changes its refractive index, and as a consequence its effective optical length changes). Each RSOA is embedded in the laser cavity (from the RSOA back facet to the Sagnac loop), hence changing the effective optical length of the RSOA by changing the current, also changes the effective optical length of the laser cavity. Changing the effective optical length of the laser cavity also changes the emission wavelength of the laser cavity.

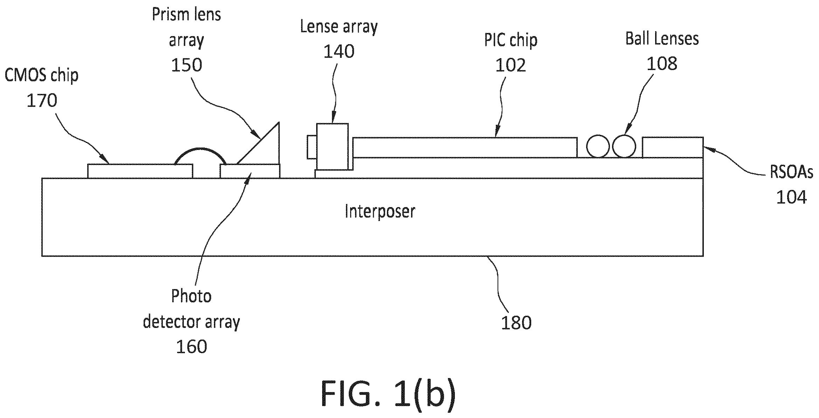

The output waveguide 118 of the laser 100 is split in two parts, the first path 120a routes multi-channel light to the chip output facet 130, and the second path 120b directs the light via an apparatus including further optical components on the chip 102 and control circuits off-chip (see FIG. 1(b)) that implements the laser stabilization.

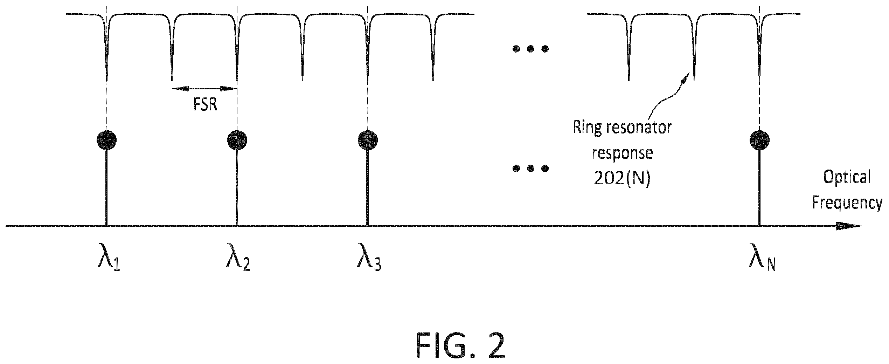

As shown, second path 120b is split again into two branches (122a, 122b). In the right branch 122a, all the synthesized frequencies are filtered by preferably a single stable high-quality factor ring resonator 124 acting as a frequency reference. The comb line frequency spacing is preferably designed to be a multiple integer of the free-spectral range (FSR) of the resonator 124. See also FIG. 2 illustrating the comb line frequency spacing.

The resonator 124 will filter amplitude and phase of all the frequencies simultaneously. A thermal phase shifter 126 can be integrated with the resonator 124 to fine tune its resonance frequency, if needed. On the left branch 122a (reference path), all the generated frequencies are passed through a nanophotonic waveguide. The output of the resonator and the reference path are each connected to a wavelength de-multiplexer (WDM) 128 (a,b).

The corresponding channels of WDMs 128(a,b) are interfered through a mixing network or circuit 132. This is to create interference pattern and discriminate frequency into amplitude for comparison and adjustment. Thermal phase shifters 134 may be provided at the output of the reference path WDM 128a to ensure proper phase condition to generate an asymmetrical error signal. This is described further by Idjadi, M.H., Kim, K. & Fontaine, N.K. Modulation-free laser stabilization technique using integrated cavity-coupled Mach-Zehnder interferometer. *Nat Commun 15,* 1922 (2024), the contents of which are hereby incorporated by reference. The outputs of the mixing circuit 132 contain 2N waveguides 136 that may be coupled out of the chip 102.

FIG. 1(b) is a side-view schematic showing an assembled laser module with its control electronics according to embodiments of the present invention. The output of the chip 102 is passed through a lens array 140 and optically coupled into an array of 2N photodetectors 160, for example, vertically via a prism 150. The photodetectors 160 may be wire bonded to a control device, preferably a CMOS chip 170 that includes electronics to process the control signal and to frequency lock the comb channels. For example, CMOS chip 170 may be configured to adjust the gain of any one of the RSOA's based on a comparison between the corresponding reference channel signal (left branch) and the corresponding filtered channel signal (right branch), which is described above as an error signal. For example, a gain current may be applied to the corresponding RSOA based on a magnitude of the error signal for the corresponding wavelength λₙ as measured by corresponding balanced photo detectors 160. That is, there are 2 photo detectors per channel, one for the reference path and one for the filtered channel signal where the photocurrents are subtracted from each other.

The entire system is preferably disposed on an interposer 180, which may be a substrate or other structure for carrying the components of the apparatus.

As illustrated in FIGS. 1(a) and 1(b), PIC 102 is a completely passive optical circuit with low loss. The skilled person will understand that the invented architecture is entirely scalable. Benefits also include uniform power and modulation free channel locking.

RSOAs 104 are shown as being positioned off-chip, but the skilled person will understand that RSOAs 104 could be incorporated into PIC 102. RSOAs are known to produce heat and require power, however, and therefore would both expand the size of chip 102 and create heat management issues. Therefore, it is preferred to position the RSOAs 104 off chip as shown in FIGS. 1(a) and 1(b).

FIG. 2 is a conceptual diagram showing the alignment of the ring resonator resonances 202_{N} for each wavelength λₙ. As mentioned, the comb line frequency spacing should be designed to be a multiple integer of the free-spectral range FSR of the high quality factor resonator.

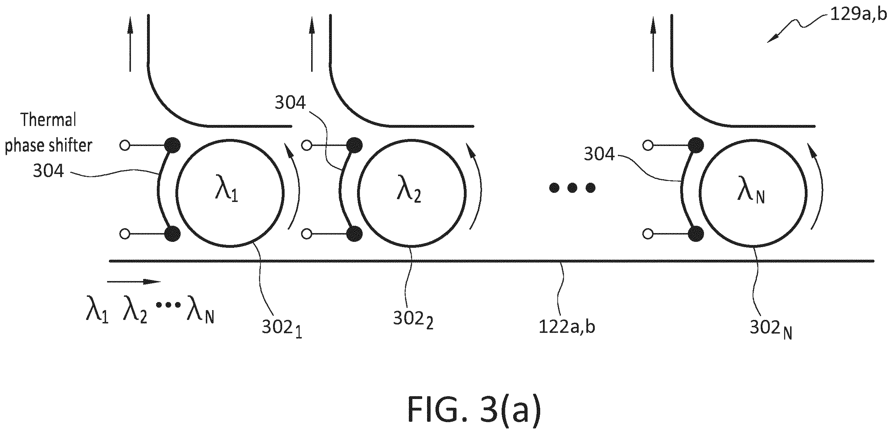

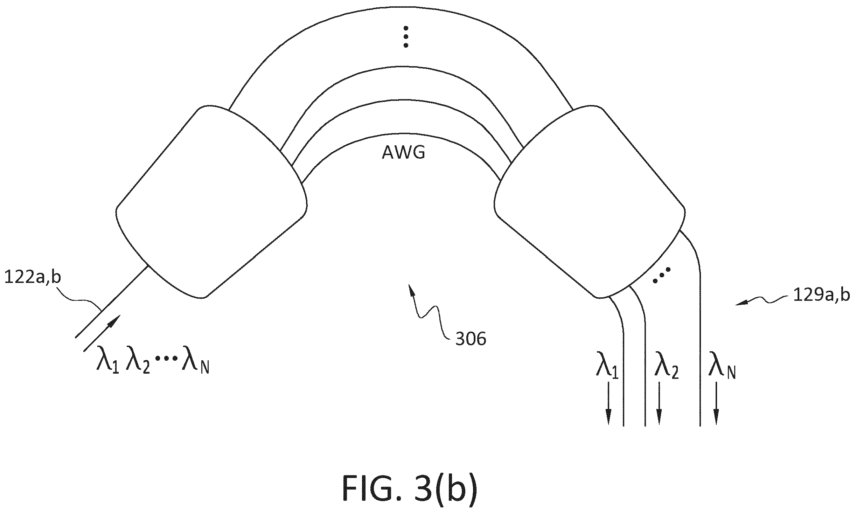

FIGS. 3(a) and 3(b) illustrate schematic diagrams of two possible architectures for WDMs 128 (a,b) according to embodiments of the present invention. As shown in FIG. 3(a), one possible architecture for the WDM (128a,b) can include an array of N ring resonators 302_{N} each aligned to each corresponding wavelength channel λₙ to create a 1xN network. Multichannel light (e.g., branches 122a, 122b) is filtered by each resonator 302_{N}. N thermal phase shifter 304 may be provided for each resonator 302. Each resonator outputs into a corresponding channel of N channels (129a, 129b) output by the WDM (128a,b).

FIG. 3(b) illustrates a schematic of a WDM (128a,b) using a 1 X N channel AWG according to embodiments of the present invention. AWG 306 receives multichannel light input (122a or 122b) and outputs into N channels (129a, 129b). AWG 306 may be conventional and designed to separate the multichannel input light signal 122a, b into its constituent wavelengths λₙ, and allow for each to be output into N channels (129a, 129b). AWG 306 may be, but need not, be a double-chirped design as described above with respect to AWG 114.

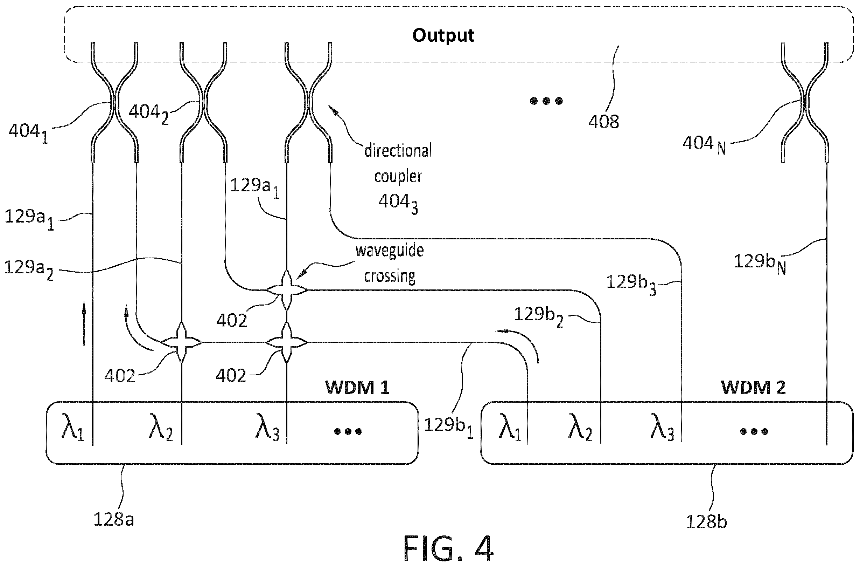

FIG. 4 shows exemplary architecture for the mixing circuit according to embodiments of the present invention. As shown, mixing circuit 400 (132) preferably includes a plurality of ultra-low loss waveguide crossings 402 to route each channel N (129a_{N}, 129b_{N}) output from WDMs 128a, 128b to a corresponding directional coupler 404_{N} so that each output 129a_{N}, 129b_{N} of WDMs 128a, 128b is interfered with. The directional couplers 404_{N} are preferably implemented using a 2x2 directional coupler or a multimode interferometer (MMI). The point is to allow the reference signal and the filtered signal to interfere and allow measuring of a difference for the purpose of frequency locking (e.g., by the photo detectors and control chip).

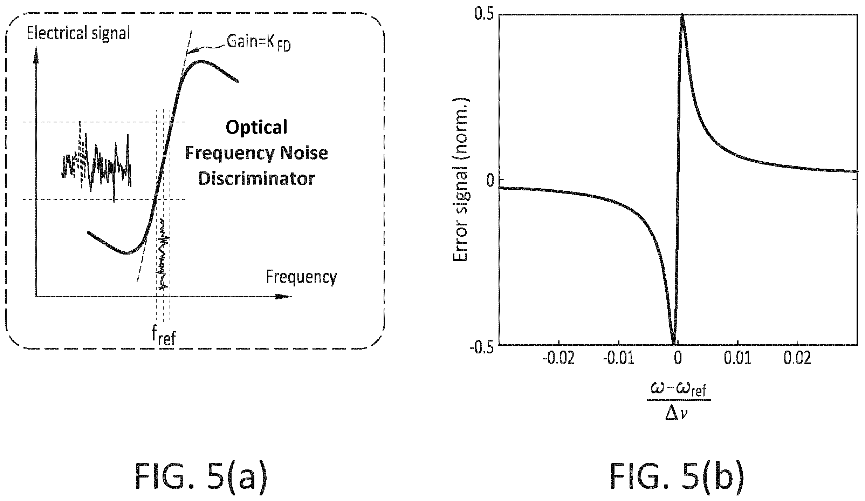

As a matter of example, ultra-low loss waveguide crossings 402 can be implemented by widening the waveguide near the crossing through taper structures. The circuit 400 will have 2N outputs 408 from the directional couplers 404N, two for each channel N (i.e., wavelength λₙ). As shown in Fig. 1(b), each of the 2N outputs may be optically coupled with a photodetector, which in turn, is electronically coupled with control circuitry for adjusting the gain of a RSOA corresponding to a channel N (i.e., wavelength λₙ) based on measurements from the photodetectors. As described, control circuit should be configured to compare the outputs of the photodetectors and determine a corresponding gain current to be applied to the relevant RSOA to lock the frequency for that channel. FIGS. 5(a) and 5(b) illustrate the conceptual diagram of the laser frequency noise discrimination and generation of the error signal. As shown in Fig. 5(a), any small perturbation in optical frequency is compared with a frequency reference and then converted into an electronic signal using photodetectors that is used as a feedback signal to adjust the current of laser RSOA and hence change its frequency. Fig. 5(a) is an exemplary graph of the electrical signal output by a photo detector plotted against frequency. To ensure that the feedback loop keeps the laser frequency locked to the reference frequency (f_{ref}), the error signal versus frequency offset, i.e., the difference between the laser frequency and f_{ref}, needs to be an asymmetric transfer function around fref (as shown in FIG. 5(a)). This asymmetry allows the loop to distinguish whether the laser frequency needs to be increased or decreased. FIG. 5(b) illustrates processing the output of the photodetector to generate an exemplary error signal indicating deviation of the optical frequency from the desired value. As shown, the electronic error signal is plotted as function on frequency offset (ω-ω_{ref}, ω is angular optical frequency) normalized to the cavity FSR (Δ*ν*).

Although specific embodiments of the invention have been described and illustrated, the invention is not to be limited to the specific forms or arrangements of parts so described and illustrated. The scope of the invention is to be defined by the claims appended hereto and their equivalents.

### List of abbreviations

The following abbreviations were used herein and are given the following meanings:
RSOA = reflective semiconductor optical amplifier
AWG = arrayed waveguide grating
HR = high-reflectivity
FSR = free-spectral-range
WDM= wavelength De-Multiplexer
MMI= Multi-Mode Interferometer
PIC= photonic integrated chip.

In this description, numerous details are set forth for the purpose of explanation. However, one of ordinary skill in the art will realize that the invention may be practiced without the use of these specific details. In other instances, well-known structures and processes are shown in block diagram form in order not to obscure the description of the invention with unnecessary detail. Thus, the present disclosure is not intended to be limited to the embodiments shown, but is to be accorded the widest scope consistent with the principles and features disclosed herein.

In describing exemplary embodiments, specific terminology is used for the sake of clarity. For purposes of description, each specific term is intended to at least include all technical and functional equivalents that operate in a similar manner to accomplish a similar purpose. Additionally, in some instances where a particular exemplary embodiment includes a plurality of system elements, device components or method steps, those elements, components or steps may be replaced with a single element, component or step. Likewise, a single element, component or step may be replaced with a plurality of elements, components or steps that serve the same purpose. Moreover, while exemplary embodiments have been shown and described with references to particular embodiments thereof, those of ordinary skill in the art will understand that various substitutions and alterations in form and detail may be made therein without departing from the scope of the invention. Further still, other embodiments, functions and advantages are also within the scope of the invention.

## Claims

1. An optical circuit, comprising:
an N by 1 channel arrayed waveguide grating (AWG) having N inputs and 1 output; an output mirror coupled with the output of the AWG;
an optical splitter splitting the output from the output mirror into three light paths, a first light path as a laser output, a second light path as a reference laser, and a third light path;
a high quality factor cavity filter coupled with the third path;
a first wavelength demultiplexer (WDM) coupled with said second light path configured to demultiplex the light in said second light path into N outputs;
a second WDM coupled with said third light path configured to demultiplex the light in said third light path into N outputs;
a mixing circuit coupled with the N outputs from the first WDM and the N outputs from the second WDM, having 2N outputs, and configured to directionally couple wavelengths (λₙ) of light outputs from the first WDM with corresponding wavelengths (λₙ) of light outputs from the second WDM, and to output into 2N waveguides the directionally coupled light paths.

2. The optical circuit of claim 1, wherein said optical circuit is formed in a photonic integrated circuit (PIC) on a single chip.

3. The optical circuit of claim 1, further comprising N waveguides which route light from a facet of the circuit to the N inputs of the AWG.

4. The optical circuit of claim 1, wherein said output mirror is implemented as a Sagnac loop positioned between the output of the AWG and the optical splitter.

5. The optical circuit of claim 1 wherein the AWG is a double-chirped design configured to suppress transmission in free-spectral-ranges adjacent to the frequency of interest.

6. The optical circuit of claim 1 wherein the AWG is implemented in silica-on-silicon waveguides.

7. The optical circuit of claim 1 wherein each WDM comprises an array of N ring resonators, each resonator being aligned with one of the wavelengths (λₙ).

8. The optical circuit of claim 1 wherein each WDM comprises a 1 to N channel AWG, with each channel being aligned with one of the wavelengths (λₙ).

9. The optical circuit of claim 1 wherein the mixing circuit comprises ultra-low-loss waveguide crossings such that every output of the first WDM and the second WDM that have corresponding wavelengths (λₙ) are interfered with using a directional coupler or interferometer.

10. An apparatus comprising:
the photonic circuit of one of the preceding claims;
an array of N reflective semiconductor optical amplifiers (RSOAs), each RSOA being optically coupled with an input of the N inputs of the AWG and configured to emit a light into the optically coupled input of the N inputs of the AWG; and
a control circuit optically coupled with the 2N outputs of said mixer circuit and electrically coupled with the array of N RSOAs, and configured to modulate a bias current to each of the N RSOAs based on a measurement of a corresponding output of the 2N outputs of said mixer circuit.

11. The apparatus of claim 10, wherein the control circuit is further configured to modulate the bias current to one or more of said N RSOAs to remove noise and lock each channel to a wavelength λₙ.

12. The apparatus of claim 10, further comprising an array of photodetectors optically coupled with each of the 2N outputs of said mixing circuit and electronically coupled with said control circuit.

13. The apparatus of claim 10, wherein the comb line frequency spacing is a multiple integer of the FSR of the resonator.

14. The apparatus of claim 10, wherein each RSOA is biased with an excitation current in the range of 0 to 300mA.

15. The apparatus of claim 10, wherein the channel spacing between wavelengths is 50-400GHz.
